# EUROPEAN PATENT APPLICATION

(11) **EP 0 845 813 A1**
(43) Date of publication of application: **03.06.1998**
(21) Application number: 96308743.2
(22) Date of filing: 02.12.1996
(51) Int. Cl.: H01L 29/739, H01L 21/331

(54) **Insulated gate bipolar transistor**

(71) Applicant: Zetex Plc, Chadderton, Oldham, OL9 8NP (GB)
(72) Inventor: Finney, Adrian, 31270 Villeneuve, Tolousane, Tolouse (FR)
(74) Representative: Prutton, Roger

(57) **Abstract**

An insulated gate bipolar transistor comprises a first layer (1) of semiconductor material of one conductivity type, an emitter electrode (6) on said first layer, a second layer (2) of semiconductor material of the opposite conductivity type adjoining said first layer, a continuous buffer layer (9) between said first and second layers of the same conductivity type material as said second layer, but of higher impurity concentration, a third layer (3) of semiconductor material of said one conductivity type overlying part of said second layer, a fourth layer (4) of semiconductor material of said opposite conductivity type overlying part of said third layer, a collector electrode (5) connected over an exposed junction between said third and fourth layers and locally shorting said third and fourth layers together, a gate electrode (8) overlying the surface of said third layer between the second and fourth layers, but insulated therefrom, a base contact region (12) overlying a portion of the second layer at a position spaced from the third layer and formed of the same conductivity type material and during the same process step as the fourth layer, a base contact electrode (11) on said base contact region and an external electrical connection (10) between said base contact electrode and the emitter electrode.

## Description

This invention relates to an insulated gate bipolar transistor (IGBT) and to a process for manufacturing an IGBT.

An IGBT conventionally comprises four layers of semiconductor material of alternately opposite conductivity type. Typically, the first layer is a substrate on which the second layer is epitaxially grown. There may be an buffer layer of the same conductivity type as the second layer between the first and second layers. The third layer is diffused into the second layer and the fourth layer is diffused into the third layer. An emitter electrode is provided on the first layer and a collector electrode locally shorts together the third and fourth layers. An insulated gate is provided over the third layer for establishing charge carrier flow into the second layer from the fourth layer. When appropriate potentials are applied to the emitter, collector and gate electrodes, the electric field exerted by the gate serves to drive away majority carriers from and attract minority carriers to the surface of the third layer adjacent the insulating oxide layer of the gate electrode, thereby creating an inversion channel through which charge carriers may pass between the second and fourth layers.

During normal operation, the p-n junction at the interface of the first and second layers is forwardly biased and not only do charge carriers flow across this junction from the second layer to the first layer, thus creating current flow between emitter and collector electrodes, but also current amplification and conductivity modulation of the second layer are provided by means of carrier injection from the first layer into the second layer.

However, when turning off inductive loads the collector electrode potential may be forced into a reverse bias condition with respect to the emitter electrode potential, thus forcing the p-n junction between the first and second layers into avalanche breakdown. This causes excessive power dissipation within the structure and irreversible damage to the device.

It has already been proposed to overcome this problem (with an n-channel IGBT) by using an external diode with the diode anode connected to the collector electrode of the IGBT and the diode cathode connected to the emitter electrode of the IGBT. This prevents a significant reverse bias potential being applied and protects the IGBT from damage. It does, however, add complication to the design of a circuit using the IGBT and increases the component count. Prior proposals for built in protection have involved expensive additional deep diffusions or buried structures.

Additionally, the turn-off speed is slow because majority carriers in the second layer are required to decay by recombination before minority carrier injection is stopped. As described in US Patent No. 5519245, it has been proposed to overcome this problem in a simple IGBT with no buffer layer, by adding a base contact region of the same conductivity type as the fourth layer. The base contact region is formed in the second layer at a position spaced from the third layer and is connected to the emitter electrode by an external conductor. The intention of this simple addition is to allow reverse current flow through the external conductor, the base contact and the second layer. However, this proposal does not provide the required solution, since the second layer is too resistive to allow significant current to flow and thereby increase the turn-off speed of the device.

US Patent No. 5519245 describes a high current IGBT which includes an externally connected base contact region as above described, but overcomes the problem of the high resistance of the second layer, by introducing a specially patterned buffer region between the first and second layers. This can carry current in the plane of the device to ensure that transients are conducted away, but holes in the buffer layer are needed to obtain high collector-emitter current flow when the device is switched on normally. This specially patterned buffer layer requires complex and expensive process steps during manufacture.

The applicants have appreciated that in applications where switching speed is of paramount importance, the holes in the buffer layer are not required and, in fact, give an inferior turn-off performance. A continuous buffer layer separating the first and second layers can be formed inexpensively during manufacture and not only gives the known advantages associated with a continuous buffer layer, but also, surprisingly, enables the use of an externally connected base contact region to resolve both the inductive transient and the switching speed problems.

The invention thus resides in the provision, in an IGBT, of a continuous buffer layer between the first and second layers and formed of material of the same conductivity type as the second layer, but of higher impurity concentration, and of a base contact region formed in the second layer at a position spaced from the third layer, said region being formed of the same conductivity type material and during the same process step as the fourth layer, an external electrical connection being provided between the base contact region and the emitter electrode.

The external electrical connection is preferably in the form of a bond wire.

The larger the surface area of the base contact region, the lower the series resistance, the faster the turn-off speed and the lower the power dissipated will be in this condition. This lower power dissipation results in higher switching efficiency in switching applications.

In accordance with another aspect of the invention there is provided a process for manufacturing an IGBT in which a continuous buffer region is formed between the first and second layers and in which a base contact region is formed of the same conductivity type material as the fourth layer at a position overlying a portion of the second layer and spaced from said third layer in the same process step as that which forms the fourth layer, and an external electrical connection is subsequently made between this base contact region and the emitter electrode.

More specifically, a process in accordance with the invention comprises the steps of:
(a) creating a substrate of a semiconductor material of one conductivity type;
(b) creating a buffer layer on one side of said substrate of semiconductor material of the opposite conductivity type;
(c) creating on said one side of said substrate a second layer of semiconductor material of said opposite conductivity type, but with lower impurity concentration;
(d) creating a gate electrode on a layer of insulation on the exposed surface of said second layer;
(e) creating on said one side of said substrate a third layer of semiconductor material of said one conductivity type extending under said gate electrode and having an exposed area smaller than the area of the substrate;
(f) creating a fourth layer of semiconductor material within the exposed area of the third layer extending under said gate electrode and of said other conductivity type;
(g) creating a collector electrode on said one side of the substrate which shorts said third and fourth layers together locally; and
(h) creating on the other side of the substrate an emitter electrode; with the improvement that it includes (i) formation during step (f) identified above of the base contact area semiconductor material of the same conductivity type as said fourth layer on said other side of the substrate at a position spaced from the third layer, (ii) the step of forming a base contact electrode on said base contact region and (iii) the additional step of providing of an external electrical connection between said base contact region and the emitter electrode.

Preferably, the process includes the further step of forming, during step (g) identified above, the base contact electrode on the base contact region.

Preferably step (f) referred to above comprises forming a mask on said one side of the substrate which leaves exposed an area of the third layer for the fourth layer and also exposes an area of the second layer for said base contact area, and creating said fourth layer and said base contact area simultaneously by diffusing the same impurity material into both exposed areas.

Step (g) referred to above preferably comprises forming a metallic layer over the substrate contacting the third and fourth layers and the base contact region but insulated from the second layer and the gate electrode, forming a mask over said metallic layer which exposes an area between the desired electrodes, and removing such area to provide separate electrodes.

In the accompanying drawings:
Figures 1 and 2 are diagrammatic sectional representations of an n-channel IGBT and a p-channel IGBT each incorporating an example of the present invention;
Figures 3 to 6 are similarly diagrammatic representations of alternative forms of IGBT construction with the same invention applied thereto; and
Figures 7a to 7p are diagrams illustrating steps in the fabrication of the device shown in Figure 1; and
Figure 8 is an equivalent circuit of the device shown in Figure 1.

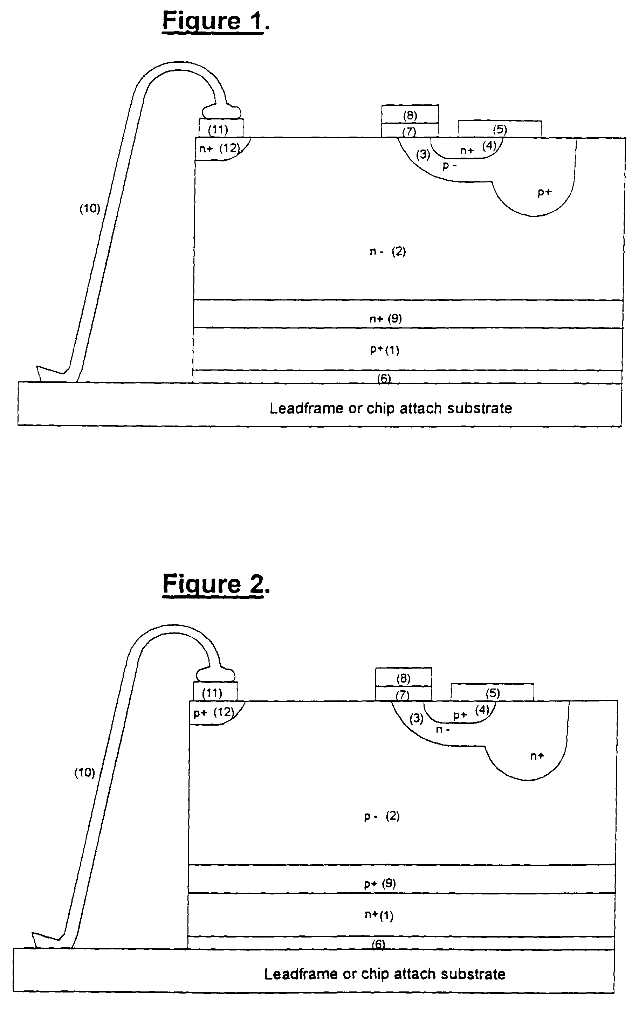

Referring firstly to Figure 1, the device shown includes a first layer 1 which is a substrate of p+ conductivity type material having an emitter electrode 6 formed by metallisation on one side of it. On the other side of layer 1 there is provided a continuous buffer layer of n+ conductivity type material and a layer 2 of n- conductivity type material. This is typically formed by epitaxial growth. The second layer 2 forms the base of the IGBT and diffused into this is a third layer 3 including a relatively shallow area of p-conductivity type material and a deeper area of p+ conductivity type material. A fourth layer 4 of n+ conductivity type material is diffused into the shallow p-area of layer 3. A collector electrode 5 is provided across the surface interface between the layer 4 and the deeper p+ area of the layer 3 and an oxide 7 insulated gate 8 is provided over the exposed surface of the shallow p- area of layer 3 between the layers 2 and 4.

The device thus far described operates as a conventional short channel n-channel IGBT. The known buffer layer 9 modifies the breakdown characteristics and the injection efficiency of the emitter-base junction and adjusts the bi-polar gain and therefore the output current switching characteristic and breakdown characteristics of the device.

To provide protection against damage by inductive transients, there is formed in the exposed surface of the base layer 2 at a position spaced from the exposed areas of the layers 4 and 3 a base contact area 12 of the same conductivity type material as the layer 4. This area is preferably in the form of a strip along the edges of the chip and is metallised, such strip being widened at one position to allow an electrode 11 to be provided. The base contact area 12 is formed at the same time as the layer 4 and the base contact electrode 11 is formed at the same time as the collector electrode 5, so that no additional process steps are required. The base contact region is the same depth as the layer 4.

The contact 11 is electrically connected by an external wire 10 to the metallisation forming the emitter electrode 6, via the lead frame or chip attachment substrate.

When the IGBT described above is used to control current flow in an inductive load, damage to the device which might otherwise be caused by inductive transients is avoided, by conducting such transients through the device along the external wire 10 via the base contact 12, the base layer 2 underlying the base contact, the layer 9, the base layer underlying the collector layer 3, and via the p-n junction formed between layers 2 and 3 which are forwardly biased in this condition. The p-n junction between the layers 1 and 9 is prevented from avalanche break-down thereby resulting in low power dissipation.

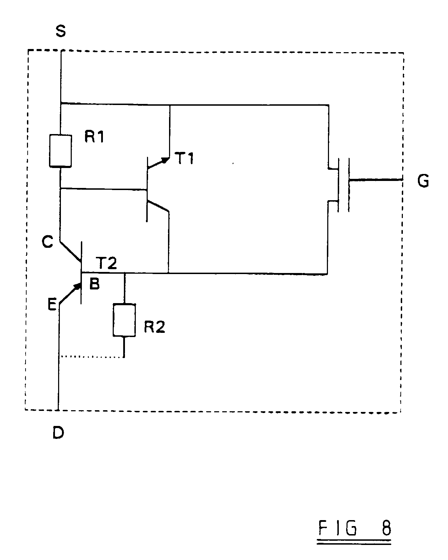

Figure 8 is the circuit equivalent of the IGBT described in this invention shown in Figure 1. When the IGBT is turned on the pnp transistor T2, formed by layers 1, 9, 2 and 3 of Fig. 1, is turned on and minority carriers are injected from the emitter of transistor T2 (layer 1 of Figure 1) into the base of transistor T2 (layers 9 and 2). The total current switched by the IGBT has both a MOSFET component and a bipolar component. The presence of a continuous layer 9 of higher concentration than the base region 2 reduces the level of minority carrier injection into the base region, reducing the bipolar current component and therefore reducing the charge required to decay during turn-off. This reduces the current tail at turn-off and thus reduces the switching losses.

The continuous layer 9 of higher concentration than layer 2 in Figure 1 effectively increases the base doping level in the base of the pnp transistor T2 shown in Figure 8. This increases the recombination rate in the base region of T2 reducing the time constant for minority carrier decay and the current tail at turn-off.

The continuous layer 9 of higher concentration than layer 2 in Figure 1 provides a better trade-off between collector-emitter breakdown voltage and on-resistance than the prior art incorporating a patterned buffer layer i.e. one in which the layer has regions of reduced thickness and/or concentration, or no buffer layer. This is because in voltage blocking mode the continuous layer 9 assists in the achievement of a high breakdown voltage which has to be supported by the depletion region between layers 2 and 3. When the depletion region between layers 2 and 3 has depleted the lightly doped layer 2 and reaches the continuous layer 9 it slows the rate of, but still allows, the spread of the depletion region between layers 2 and 3. Because the continuous layer 9 is of higher conductivity than the lightly doped layer 2 the additional voltage supported by layer 9 is achieved at a minimal detriment to on-resistance. This is an advantage over the prior art incorporating a patterned buffer layer i.e. one in which the layer has regions of reduced thickness and/or concentration, or no buffer layer, as in these cases thicker n- base layers will be required to achieve the same breakdown voltage at a greater detriment to on-resistance and switching speed.

The turn-off speed of the IGBT is dependent on the turn-off speed of the transistor T2. In IGBTs without a short between layers 1 and 2 the turn-off speed is slow because the transistor T2 has an open base connection. Under these conditions the majority carriers in the base provided by the base current decay by recombination and whilst they do so the injection of minority carriers continues, sustaining the current flow and delaying the transistor turn off. It is well known that the turn-off speed of a bipolar transistor is increased when the base and emitter terminals are shorted together thereby providing a route for the majority carriers to escape turning off the transistor T2 much faster.

The series resistance of the emitter-base short determines how quickly the majority carriers are removed from the base and therefore how fast the transistor turns off. In the device shown in Figure 1 the series resistance of the base-emitter short is minimised by the incorporation of a continuous layer 9 of high conductivity. Majority carriers are thus removed from the base layer 2 via the layer 9, via the base layer 2 underlying the base contact region 12, via the base contact metallisation 11 and external connection 10. IGBTs incorporating external anode shorts without a buffer layer 9 are ineffective in increasing the turn-off speed due to the high lateral resistance of the base layer 2. IGBTs which incorporate a patterned buffer layer 9 i.e. one in which the layer has regions of reduced thickness and/or dopant concentration, introduce extra resistance in the emitter-base short and thus do not turn off as quickly.

When switching off inductive loads the continuous layer 9 of higher concentration than layer 2 in Figure 1 provides a lower resistance path for reverse transient currents to pass than the provision of an external short and a patterned buffer layer 9 i.e. one in which the layer has regions of reduced thickness and/or dopant concentration or same with no buffer layers or buffer layers without external short, thereby ensuring that the reverse current is evenly distributed across the area of the chip and preventing avalanche breakdown of the back junction thus ensuring minimal resistance and power dissipation during reverse conduction of the transient.

The structure of the device shown in Figure 1 is much simpler to manufacture than those cited in the prior art incorporating a patterned layer 9 i.e. one in which the layer has regions of reduced thickness and/or dopant concentration, or those providing an anode short in the semiconductor bulk or by deep base contact diffusions which extend through the base layer 2 and contact the layer 9. Therefore it is both cheaper and more robust.

The IGBT device described is manufactured by the usual process involving growing the layers 9 and 2 on the substrate forming the first layer 1, and then carrying out a series of successive masking operations to create masks through which impurity materials are diffused to form the third and fourth layers. This general process is well-known and will not be described in detail herein. The process is such that, when the mask for the fourth layer 4 is printed on to the surface of the wafer, it has openings exposing not only the desired area of the fourth layer, but also openings exposing the area of the second layer where the base contact area is to be formed. The same n-type impurity material is then diffused through these openings in a single diffusion step to form the layer 4 and the base contact area 12 simultaneously. The layer 4 and the area 12 are therefore of substantially the same thickness.

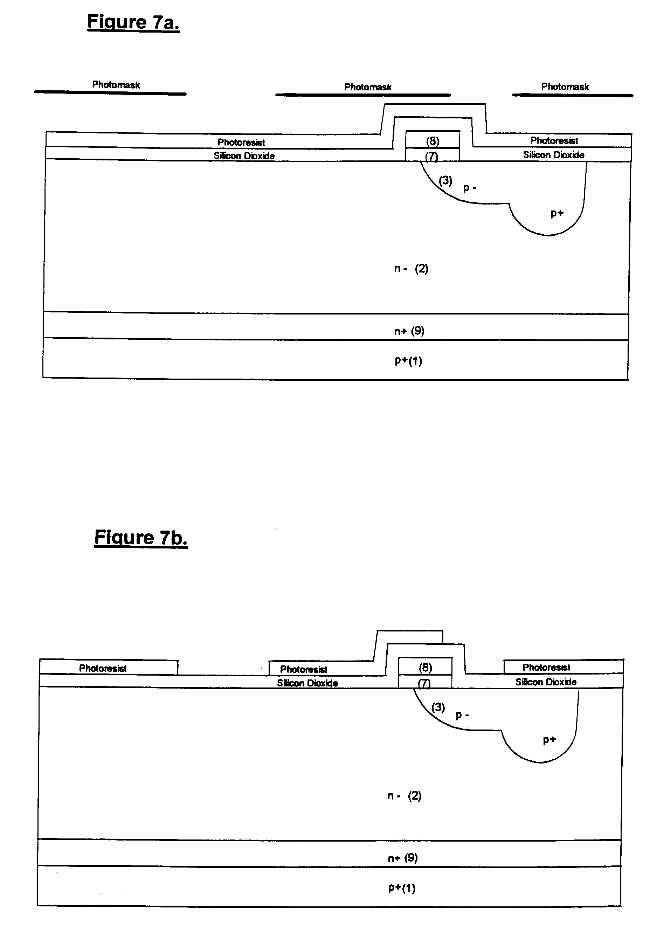

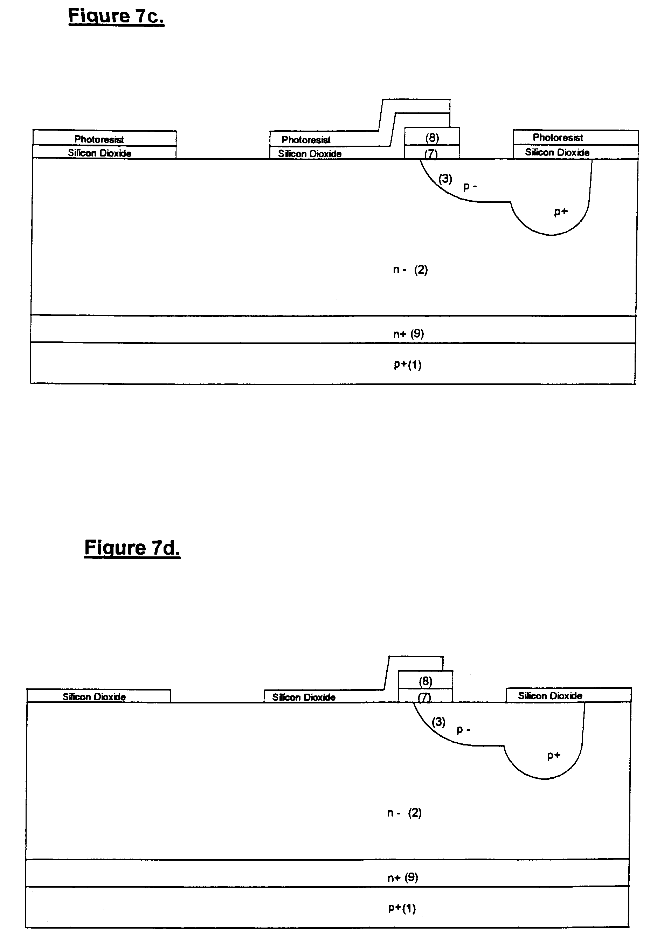

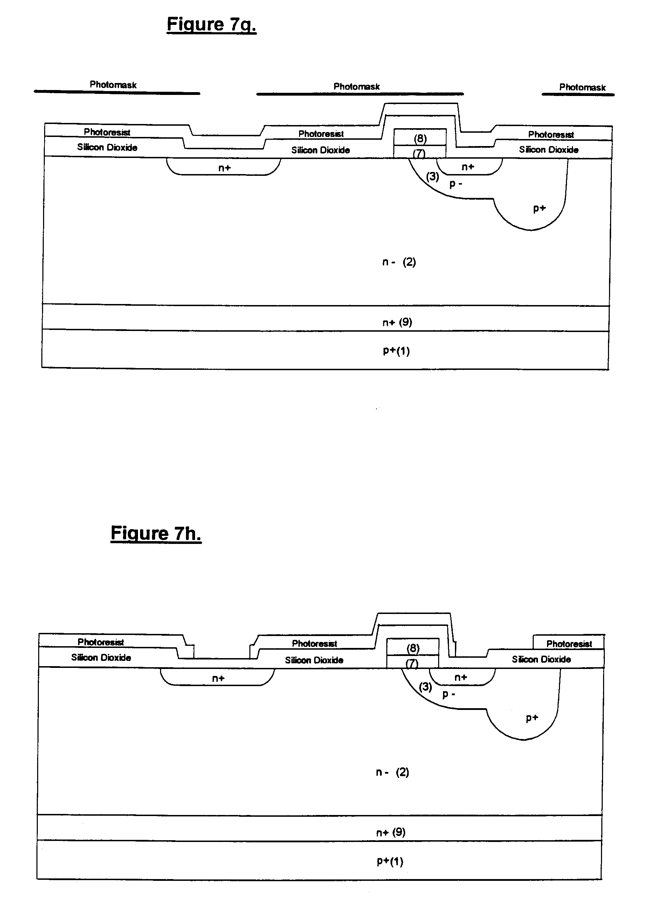

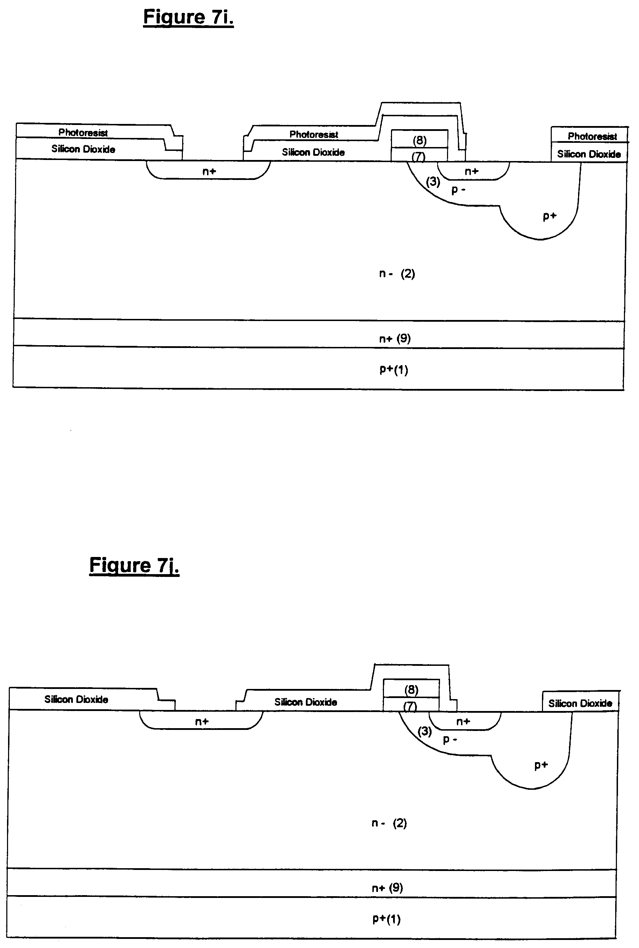

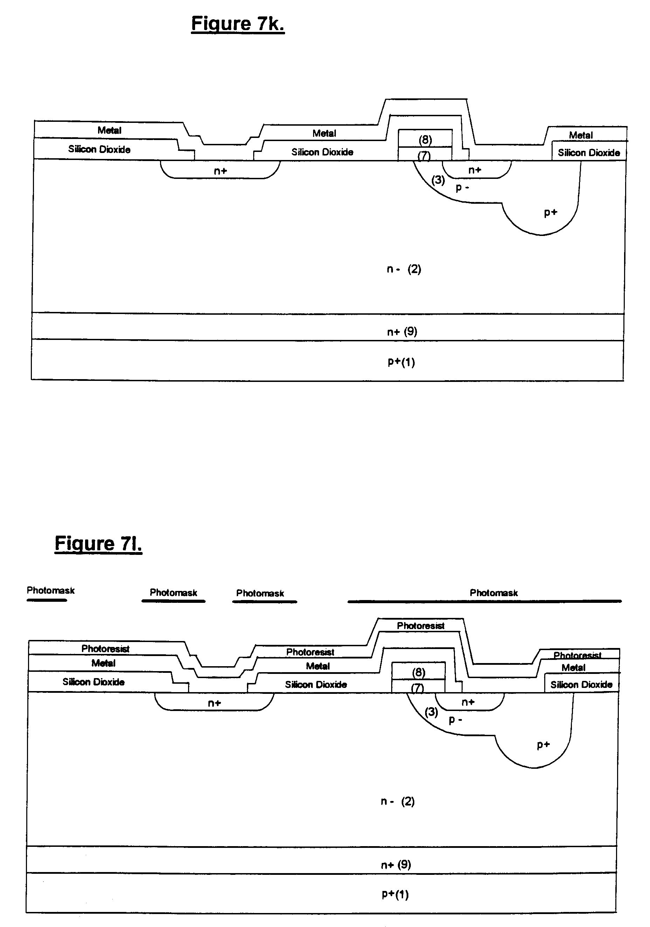

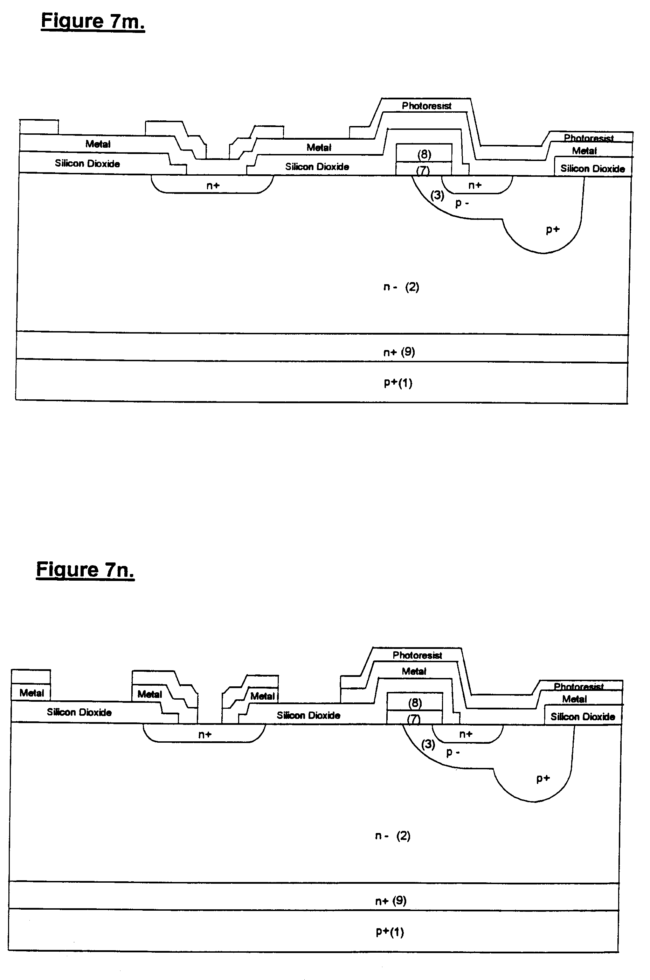

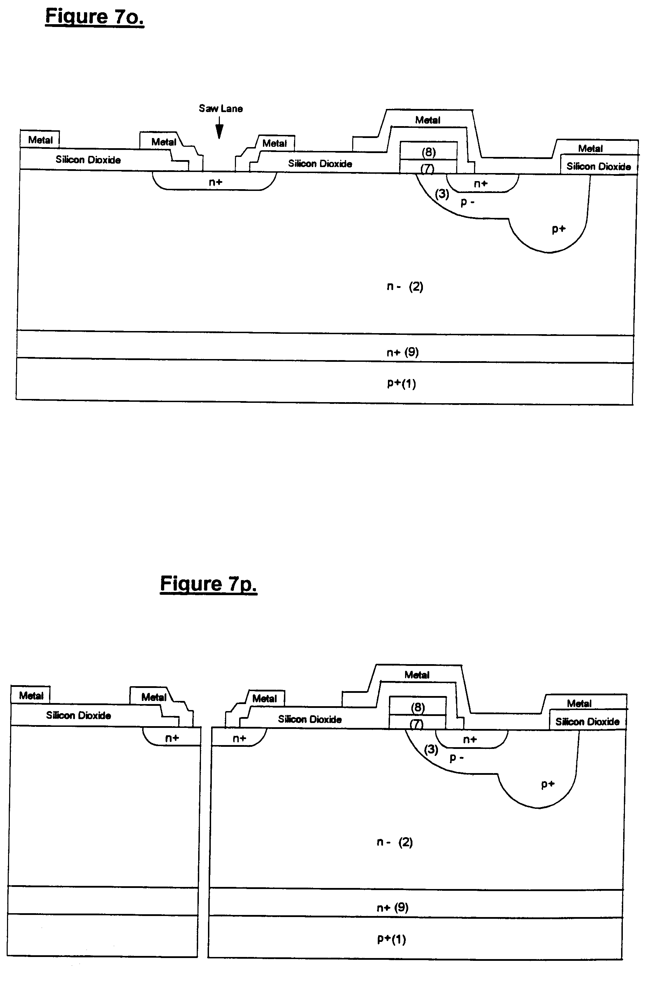

Figures 7a to 7p show the steps involved in forming the base contact region 12 and its electrode 11 in detail. Figure 7a shows the wafer after the formation of the layers 1, 9 and 2 and of the gate electrode 8 and its insulation layer 7 and the subsequent formation of layer 3 so that it extends under the gate electrode. Figure 7a shows a silicon dioxide layer and a photo-resist layer over the whole surface of the wafer and a photo-mask over the photo-resist layer. Figure 7b shows the wafer after exposure and development of the photo-resist layer. Figure 7c shows the wafer after etching of the silicon dioxide layer through the openings in the photo-resist layer to form an oxide mask for the next diffusion step and 7d shows the masked wafer after removal of the photo-resist layer.

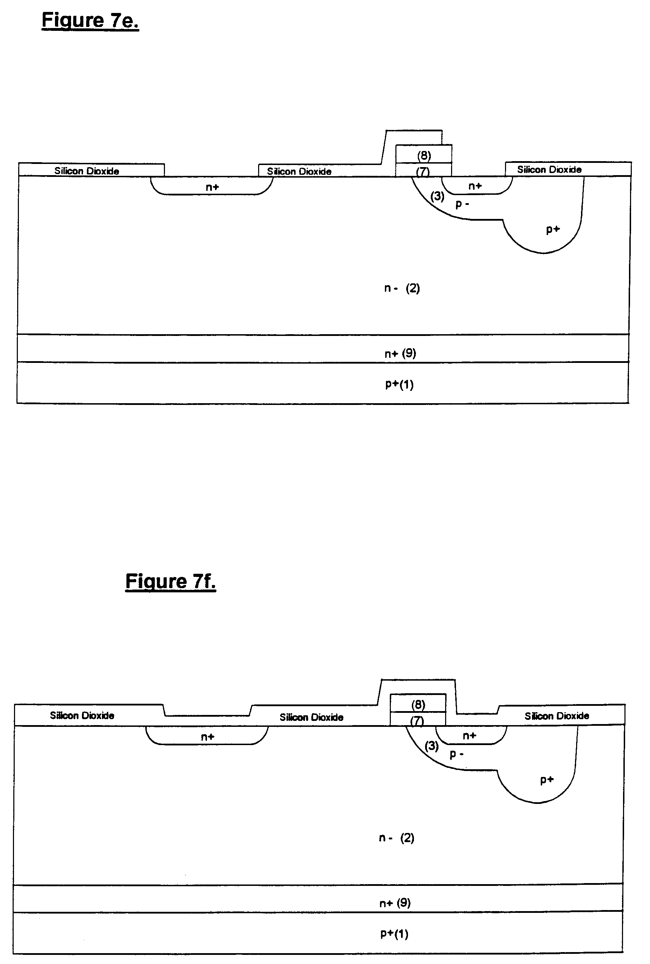

Figure 7e shows the wafer after the diffusion step which simultaneously forms base contact region and the fourth layer. It will be noted at this point that the opening in the silicon dioxide mask for the fourth layer actually overlaps gate electrode 8 so that the edge of the gate actually defines the surface boundary of the fourth layer. It will be noted that the fourth layer extends under the insulation 7. Figures 7f and 7g show the deposition of a new overall silicon dioxide layer and a new photo-resist layer. Another photo-mask is used to expose the new photo-resist layer which is then developed to result in the structure shown in Figure 7h. Figures 7i and 7j show the wafer after etching of the silicon dioxide layer and removal of the photo-resist.

Figure 7k shows the wafer covered overall with a metallisation layer and Figure 7l shows the wafer with a further photo-resist layer over the metallisation layer with a photo-mask in place ready for exposure of the photo-resist. Figures 7m and 7n show the wafer after development of the further photo-resist layer and a metal etching step respectively. Figure 7o shows the completed wafer after removal of the further photo-resist layer and Figure 7p shows the wafer after cutting into separate chips.

Forming the base contact region 12 in the same process step as the collector region 4 obviates the need for additional process steps, often involving deep diffusions or buried structures which have previously been proposed. Formation of the base contact electrode in the same process step as the collector electrode likewise obviates the need for added process steps. This significantly reduces chip fabrication costs as compared with such previous proposals.

Figure 2 shows a corresponding p-channel IGBT and will not be described in detail.

It should be noted that the invention is equally applicable to cellular, interdigitated, V-groove and trench etched IGBT structures, the base contact region 12 being formed in each case in the same process step as the collector region 4 and the base contact electrode 11 is formed in the same process step as the collector electrode 5.

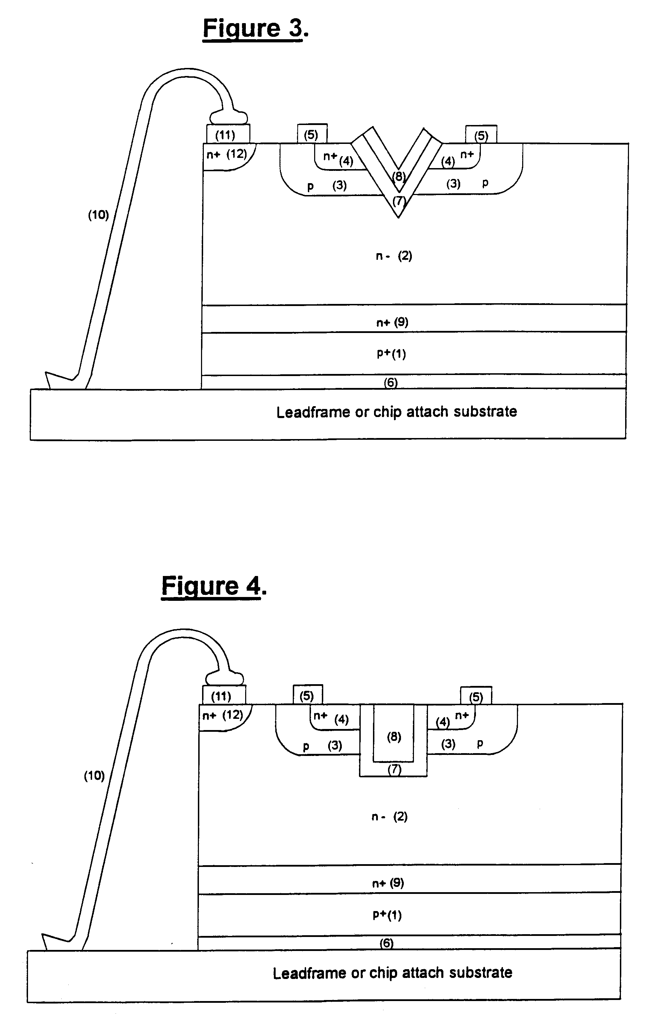

Figure 3 shows a typical V-groove IGBT structure having the present invention applied thereto. It will be understood by those skilled in the art that in this construction a V-groove is cut in the surface of the device, through the third and fourth layers 3 and 4 into the second layer 2. The oxide insulation 7 is deposited in this groove and the gate electrode 8 is formed over it.

Figure 4 shows a typical trench gate IGBT which is similar in topography to the V-groove IGBT of Figure 3 except that the trench or groove has walls approximately perpendicular to the plane of the substrate.

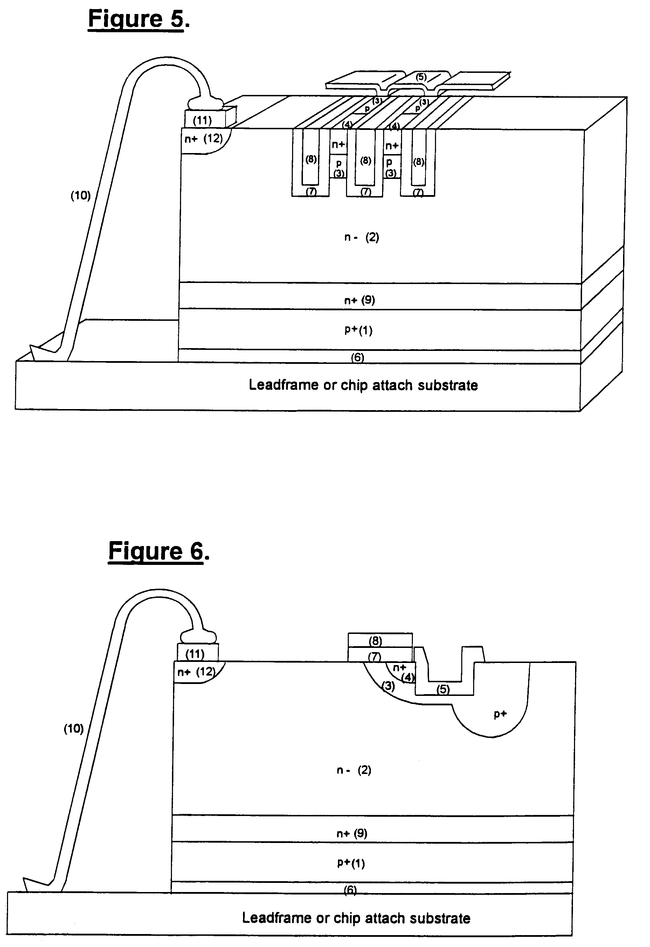

Figure 5 shows another example of a trench gate IGBT. In this case there are several parallel trenches cut in the surface of the device and these intersect the surface boundary (or boundaries) between the third and fourth layers 3 and 4. The collector electrode 5 has portions which contact areas of third and fourth layers 3 and 4 in between the trenches.

As in Figure 4, the gate electrode 8 and its insulation layer 7 are provided in each of the trenches. Further, as in Figure 3, there is a base contact area 12 with a contact electrode 11 at a position remote from the gate and collector structures. The base contact area 12 is formed in the same process step as the layer 4 and the electrode 11 is formed in the same process step as the electrode 5. The invention is equally applicable to cellular trench IGBTs.

Figure 6 shows the structure of a trench collector IGBT. It will be seen that this device differs from that shown in Figure 1 in that collector electrode is formed in a trench cut along the boundary of layer 4 adjacent the deeper area of p+conductivity material forming part of the third layer 3. The base contact area 12 and its contact electrode 11 are exactly the same as those shown in Figure 1.

In an alternative fabrication process, which is not illustrated in the accompanying drawings, the layer 2 forms the original substrate. All the steps of forming layer 3 in this and the succeeding steps which are described above are carried out. The back of the wafer is then ground down to achieve the desired wafer thickness and layers 9 and 1 are subsequently formed by diffusion before the emitter electrode is deposited on layer 1. The invention is equally applicable to IGBTs fabricated in this way.

It should be noted that the terms emitter and collector have been used herein in a manner which reflects the actual semi-conductor physics of the device. The terms are, however, frequently interchanged by users of the device to represent the way in which the devices are actually connected in circuits.

## Claims

1. An insulated gate bipolar transistor comprising a first layer of semiconductor material of one conductivity type, an emitter electrode on said first layer, a second layer of semiconductor material of the opposite conductivity type adjoining said first layer, a continuous buffer layer between the first and second layers formed of a material of the same conductivity type as the second layer but of higher impurity concentration, a third layer of semiconductor material of said one conductivity type overlying part of said second layer, a fourth layer of semiconductor material of said opposite conductivity type overlying part of said third layer, a collector electrode connected over an exposed junction between said third and fourth layers and locally shorting said third and fourth layers together, a gate electrode overlying the surface of said third layer between the second and fourth layers, but insulated therefrom, a base contact region overlying a portion of the second layer at a position spaced from the third layer and formed of the same conductivity type material and during the same process step as the fourth layer, a base contact electrode on said base contact region and an external electrical connection between said base contact electrode and the emitter electrode.

2. An insulated gate bipolar transistor as claimed in Claim 1, in which said base contact electrode is formed in the same process step as the collector electrode.

3. An insulated gate bipolar transistor as claimed in Claim 1 or Claim 2, in which said external electrical connection is in the form of a bond wire.

4. A process for manufacturing an insulated gate bipolar transistor which includes a first layer of semiconductor material of one semiconductor type, an emitter electrode on said first layer, a second layer of semiconductor material of the opposite conductivity type adjoining said first layer, a continuous buffer layer between the first and second layers formed of the same conductivity type material as the second layer but of higher impurity concentration, a third layer of semiconductor material of said one conductivity type overlying part of said second layer, a fourth layer of semiconductor material of said opposite conductivity type overlying part of said third layer, a collector electrode connected over an exposed junction between said third and fourth layers and locally shorting said third and fourth layers together and a gate electrode overlying the surface of said third layer between the second and fourth layers, but insulated therefrom; said process including the steps of (i) forming a base contact region of the same conductivity type material as said fourth layer as part of a process step which creates said fourth layer, said base contact region being spaced from the fourth layer, (ii) providing an electrode on said base contact region and (iii) providing an external electrical connection between said base contact electrode and said emitter electrode.

5. A process as claimed in Claim 4, wherein the step (ii) of forming a base contact electrode on the base contact region is part of a process step which creates said collector electrode.

6. A process for manufacturing an IGBT comprising the steps of
(a) creating a substrate of a semiconductor material of one conductivity type;
(b) creating a continuous buffer layer on one side of said substrate of semiconductor material of the opposite conductivity type;
(c) creating on said one side of said substrate a second layer of semiconductor material of said opposite conductivity type, but with lower impurity concentration;
(d) creating a gate electrode on a layer of insulation on the exposed surface of said second layer;
(e) creating on said one side of said substrate a third layer of semiconductor material of said one conductivity type extending under said gate electrode and having an exposed area smaller than the area of the substrate;
(f) creating a fourth layer of semiconductor material within the exposed area of the third layer extending under said gate electrode and of said other conductivity type;
(g) creating a collector electrode on said one surface of the substrate which shorts said third and fourth layers together locally; and
(h) creating on the other side of the substrate an emitter electrode; with the improvement that it includes (i) formation during step (f) identified above of the base contact area semiconductor material of the same conductivity type as said fourth layer on said other side of the substrate at a position spaced from the third layer, (ii) the step of forming a base contact electrode on said base contact region and (iii) the additional step of providing of an external electrical connection between said base contact region and the emitter electrode.

7. A process as claimed in Claim 6, in which the step (ii) of formation of a base contact electrode on the base contact region, is part of step (g).

8. A process as claimed in Claim 6, in which step (f) defined therein comprises forming a mask on said one side of the substrate which leaves exposed an area of the third layer for the fourth layer and also exposes an area of the second layer for said base contact area, and creating said fourth layer and said base contact area simultaneously by diffusing the same impurity material into both exposed areas.

9. A process as claimed in Claim 8, in which step (g) referred to therein comprises forming a metallic layer over the substrate contacting the third and fourth layers and the base contact region, but insulated from the second layer and the gate electrode, forming a mask over said metallic layer which exposes an area between the desired electrodes and removing such area to provide separate electrodes.
